# EUROPEAN PATENT APPLICATION

(11) **EP 3 957 777 A1**
(43) Date of publication of application: **23.02.2022**
(21) Application number: 20790913.6
(22) Date of filing: 08.04.2020
(51) Int. Cl.: C30B 25/14, H01L 21/205, C30B 29/36, C23C 16/42, C23C 16/44

(54) **SIC EPITAXIAL GROWTH APPARATUS**

(30) Priority: 15.04.2019 JP 2019077204
(71) Applicant: NuFlare Technology, Inc., Yokohama-shi, Kanagawa 235-8522 (JP)
(72) Inventor: MIZUSHIMA Ichiro, Yokohama-shi, Kanagawa 235-8522 (JP); DAIGO Yoshiaki, Yokohama-shi, Kanagawa 235-8522 (JP); MORIYAMA Yoshikazu, Yokohama-shi, Kanagawa 235-8522 (JP)
(74) Representative: Hoffmann Eitle
(86) International application number: PCT/JP2020/015890
(87) International publication number: WO 2020/213503

(57) **Abstract**

A SiC epitaxial growth apparatus according to an embodiment includes: a chamber into which a process gas at least containing silicon and carbon is introduced, the chamber being capable of housing a substrate to undergo film deposition with the process gas; piping that discharges a gas containing a byproduct generated through film deposition on the substrate from the chamber; and a valve for pressure control provided in a middle of the piping. The valve has a flow inlet into which the gas flows from an upstream portion of the piping that causes the chamber and the valve to connect with each other, and a flow outlet that allows the gas to flow out to a downstream portion of the piping that connects with the upstream portion via the valve. a part of the upstream portion is provided at least at a position lower than the flow inlet or a part of the downstream portion is provided at a position lower than the flow outlet.

## Description

### [Technical Field]

Embodiments of the present invention relate to a SiC epitaxial growth apparatus.

### [Background Art]

A SiC epitaxial growth apparatus is one of epitaxial growth apparatuses which allow a thin film to be uniformly deposited on a wide-area single crystal substrate. The SiC epitaxial growth apparatus deposits a SiC single crystal thin film on the substrate using a process gas containing silicon (Si), carbon (C) and the like.

### [Citation List]

### [Patent Literature]

[Patent Literature 1] Japanese Patent publication No. 2010-222148

### [Summary of Invention]

### [Technical Problem]

The SiC epitaxial growth apparatus discharges a byproduct generated through SiC film deposition. The byproduct commonly has danger of explosion. In particular, when the film deposition gas contains chlorine, a byproduct having fluidity is generated. Its removal particularly needs consideration of safety.

It has been revealed that such a byproduct is liquefied near a valve for pressure control in an exhaust piping, that is, at a position where the pressure fluctuates thereon. Further, the liquified byproduct tends to remain at the valve since its viscosity is relatively high. This requires highly frequent replacement and/or cleaning of the valve.

An embodiment of the present invention provides a SiC epitaxial growth apparatus capable of making a byproduct caused by SiC epitaxial growth scarcely remain on a valve provided in the middle of a discharge passage and reducing the frequency of replacement and/or cleaning on the valve.

### [Solution to Problem]

A SiC epitaxial film deposition apparatus according to an embodiment includes: a chamber that a raw material gas at least containing silicon and carbon is introduced into and that is capable of housing a substrate to undergo film deposition with the raw material gas; piping that discharges a gas containing a byproduct generated through film deposition on the substrate from the chamber; and a valve for pressure control provided in a middle of the piping. The valve has a flow inlet into which the gas flows from an upstream portion of the piping that causes the chamber and the valve to connect with each other, and a flow outlet that allows the gas to flow out to a downstream portion of the piping that connects with the upstream portion via the valve. A part of the upstream portion is provided at least at a position lower than the flow inlet or a part of the downstream portion is provided at a position lower than the flow outlet.

### [Advantageous Effects of Invention]

According to an embodiment, the byproduct caused by SiC epitaxial growth can be made scarcely remain on the valve provided in the middle of the discharge passage, and the frequency of replacement of the valve can be reduced.

### [Brief Description of Drawings]

Figure 1 is a view showing a schematic configuration of a SiC epitaxial growth apparatus according to a first embodiment.
Figure 2 is a view showing a schematic configuration of a SiC epitaxial growth apparatus according to a comparative example.
Figure 3 is a schematic diagram showing a modification in which a flow outlet of a valve is arranged downward obliquely.
Figure 4 is a graph showing relationship between a piping diameter and the amount of a remaining byproduct.
Figure 5 is a piping structure used for experimental results shown in Figure 4.
Figure 6 is a graph showing piping lengths at which byproduct amount ratios are 0.05 based on the experimental results shown in Figure 4.
Figure 7A is a schematic diagram showing a modification in which a trap part is arranged more on the downstream side than the lowermost part of an upstream portion.
Figure 7B is a schematic diagram in which the trap part is arranged more on the upstream side than the lowermost part of a downstream portion.
Figure 8A is a schematic diagram showing a modification, of the valve, in which a flow inlet and a flow outlet open in the vertical direction.
Figure 8B is a schematic diagram showing a modification, of the valve, in which the flow inlet and the flow outlet open in the horizontal direction.
Figure 9A is a schematic diagram showing a modification in which a trap branches from the piping.
Figure 9B is a schematic diagram showing another modification in which a trap branches from the piping.
Figure 9C is a schematic diagram showing still another modification in which traps branch from the piping.
Figure 10 is a view showing a schematic configuration of a SiC epitaxial growth apparatus according to a second embodiment.

### [Description of Embodiments]

Embodiments will now be explained with reference to the accompanying drawings. The present invention is not limited to the embodiments.

### (First Embodiment)

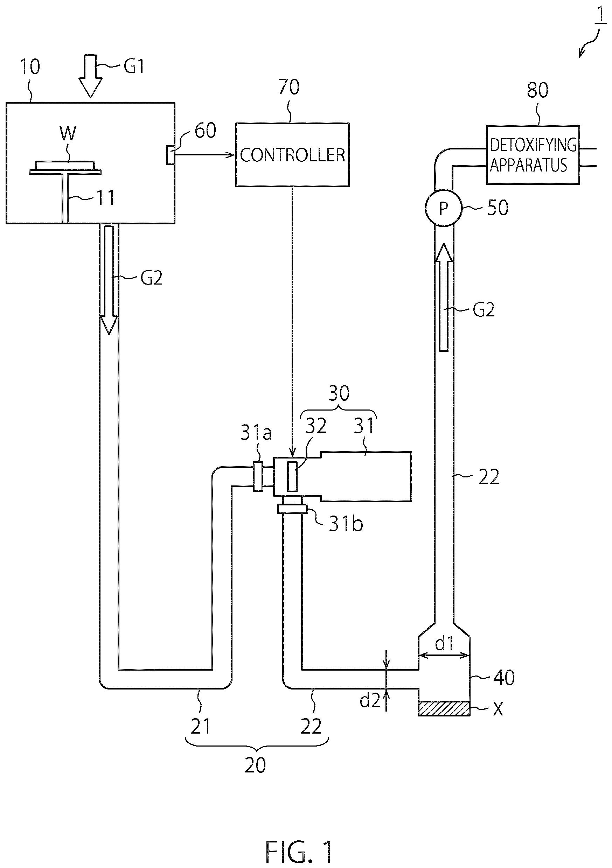

Figure 1 is a view showing a schematic configuration of a SiC epitaxial growth apparatus according to a first embodiment. In the present embodiment, a semiconductor wafer W is used as a substrate which undergoes epitaxial growth processing, and description will be made as to an example of vapor-phase epitaxial growth of a single film on this semiconductor wafer W or of a plurality of thin films stacked thereon.

A SiC epitaxial growth apparatus 1 shown in Figure 1 includes a chamber 10, piping 20, a valve 30, a trap part 40, a pump 50, a pressure sensor 60, a controller 70 and a detoxifying apparatus 80. The constituents of the SiC epitaxial growth apparatus 1 will be hereafter described.

In the chamber 10, the semiconductor wafer W is contained in the state of being placed on a stage 11. One wafer may be placed or a plurality of wafers may be placed simultaneously. Then, a process gas G1 is introduced into the chamber 10. In the present embodiment, the process gas G1 contains silicon, carbon, and chlorine (CI). As a gas containing silicon, monosilane (SiH₄), dichlorosilane (SiH₂Cl₂), or trichlorosilane (SiHCl₃) can be used, for example. As a gas containing carbon, propane (C₃H₈) or acetylene (C₂H₂) can be used, for example. As a gas containing chlorine, hydrogen chloride (HCl) can be used, for example. Hydrogen (H₂) or argon (Ar) as a carrier gas may be flown simultaneously. Moreover, nitrogen (N₂) or trimethylaluminum (TMAI) may be added as a dopant gas. When this process gas G1 is introduced into the chamber 10 and the wafer is heated, for example, at 1650°C with a heating source (not shown) such as a heater, a SiC single crystal thin film is deposited on the semiconductor wafer W and a byproduct is generated simultaneously.

In the present embodiment, the byproduct is a polymer at least containing silicon, hydrogen (H), chlorine, and carbon. An exhaust gas G2 is discharged from the chamber 10 to the piping 20, and thereby, the byproduct as the polymer is generated at a portion which is on or downstream of the piping 20 and where gas can flow.

The piping 20 has an upstream portion 21 which causes the chamber 10 and the valve 30 to connect with each other, and a downstream portion 22 connecting with the upstream portion 21 via the valve 30. In the present embodiment, as shown in Figure 1, one end of the upstream portion 21 is connected to the bottom surface of the chamber 10. Otherwise, the one end of the upstream portion 21 may be connected to the lateral surface of the chamber 10.

As shown in Figure 1, each of the upstream portion 21 and the downstream portion 22 bends into a U shape. Namely, each has a place bending at its lower part. The valve 30 is set between an upper end part of the upstream portion 21 and an upper end part of the downstream portion 22.

The valve 30 has a valve casing 31 and a valve body 32. On the valve casing 31, a flow inlet 31a and a flow outlet 31b are equipped. The exhaust gas G2 discharged from the chamber 10 to the upstream portion 21 of the piping 20 flows into the flow inlet 31a. In the present embodiment, the flow inlet 31a opens in the horizontal direction and is connected to the upper end part of the upstream portion 21 bending in a U shape.

The flow outlet 31b allows the exhaust gas G2 having flowed into the flow inlet 31a to flow out to the downstream portion 22. In the present embodiment, the flow outlet 31b opens downward in the vertical direction and is connected to the upstream-side upper end part of the downstream portion 22 bending in a U shape.

The valve body 32 operates in the valve casing 31 based on control by the controller 70. The operation of the valve body 32 changes the degree of opening of the valve 30, in other words, the flow pressure of the exhaust gas G2 at the flow inlet 31a. Controlling the operation of the valve body 32 can result in control of inner pressures in the upstream portion 21 of the piping 20 and the chamber 10.

The trap part 40 is installed in the lower end part of the downstream portion 22 bending in the U shape. Namely, the trap part 40 is installed at a position lower than the valve 30. Thereby, a byproduct X which is discharged from the flow outlet 31b of the valve 30 is collected in a lower part of the trap part 40. Moreover, as shown in Figure 1, the lower part of the trap part 40 is provided below the piping 22, and an inner diameter "d1" of the trap part 40 is sufficiently larger than an inner diameter "d2" of the piping 22. Since the trap part 40 namely has a sufficiently larger sectional area in a plane perpendicular to the direction in which the exhaust gas G2 flows than the piping 22, a pass of the flow of the exhaust gas G2 is secured in the trap part 40 even when the byproduct X is collected in the trap part 40. Therefore, the flow of the exhaust gas G2 is not disturbed in the downstream portion 22.

Note that increase in amount of the byproduct X collected in the trap part 40 requires replacement of the trap part 40. Therefore, at least the downstream portion 22 of the trap part 40 is desirably interchangeably attached. Notably, while a method of attaching the trap part 40 to the downstream portion 22 is not particularly limited, a simple method is desirable for the sake of reduction in time required for replacement work. Another trap part 40 may be provided on the upstream portion 21 as well as that on the downstream portion 22.

The pump 50 is a vacuum pump installed downstream of the trap part 40. The pump 50 operates to evacuate the interior of the piping 20 and the interior of the chamber 10 into a vacuum state. This evacuation operation allows the exhaust gas G2 to be sucked into the piping 20 from the chamber 10.

The pressure sensor 60 is installed in the chamber 10. Otherwise, it may be installed on the upstream portion 21 of the piping 20. The pressure sensor 60 detects the inner pressure in the chamber 10 to output it to the controller 70.

The controller 70 receives the result of monitoring, with the pressure sensor 60, the pressure inside the chamber 10 in the SiC epitaxial growth apparatus 1. The controller 70 controls the degree of opening of the valve 30 such that the pressure in the chamber 10 becomes a pressure suitable for vapor-phase epitaxial growth such as 200 Torr or becomes a pressure suitable for each of the steps of film deposition processing. The controller 70 controls introduction of the process gas G1 and discharge of the exhaust gas G2.

The detoxifying apparatus 80 is provided for removing or detoxifying harmful gas contained in the exhaust gas G2, which can be thus released to the air.

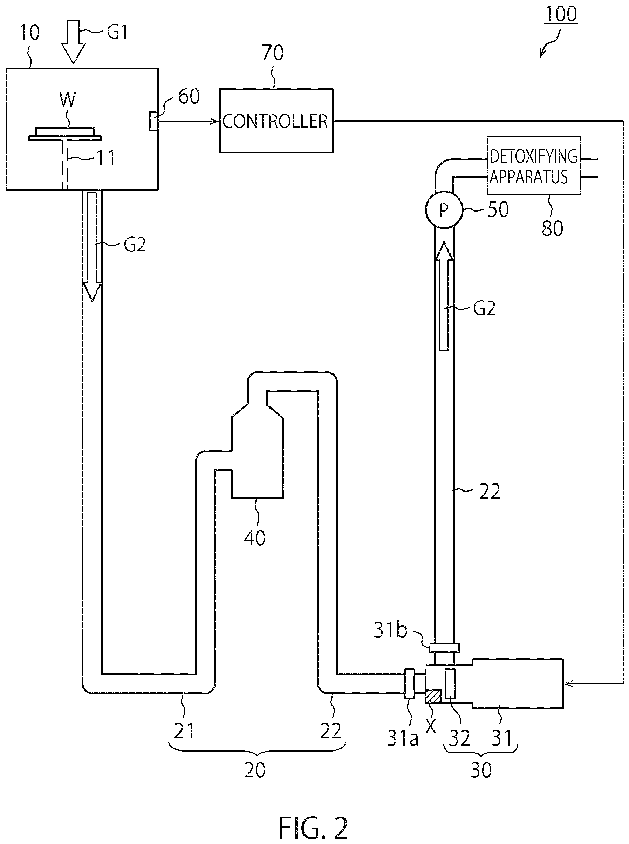

Figure 2 is a view showing a schematic configuration of a SiC epitaxial growth apparatus according to a comparative example. In Figure 2, the similar constituents to those of the SiC epitaxial growth apparatus 1 shown in Figure 1 are given the same signs and their detailed description is omitted.

In a SiC epitaxial growth apparatus 100 shown in Figure 2, the valve 30 is connected to the downstream portion 22 of the piping 20 at a position lower than the trap part 40. Moreover, the flow outlet 31b of the valve 30 opens upward in the vertical direction. Therefore, the byproduct X contained in the exhaust gas G2 tends to adhere easily to the interior of the valve casing 31 of the valve 30.

On the other hand, according to the present embodiment, as shown in Figure 1, the flow outlet 31b of the valve 30 opens downward in the vertical direction. Therefore, the byproduct X attaching to the vicinity of the flow outlet 31b in the valve casing 31 is guided to be discharged from the flow outlet 31b with the gravity. Since the byproduct X accordingly scarcely adheres to the interior of the valve casing 31, the frequency of replacement of the valve 30 can be reduced.

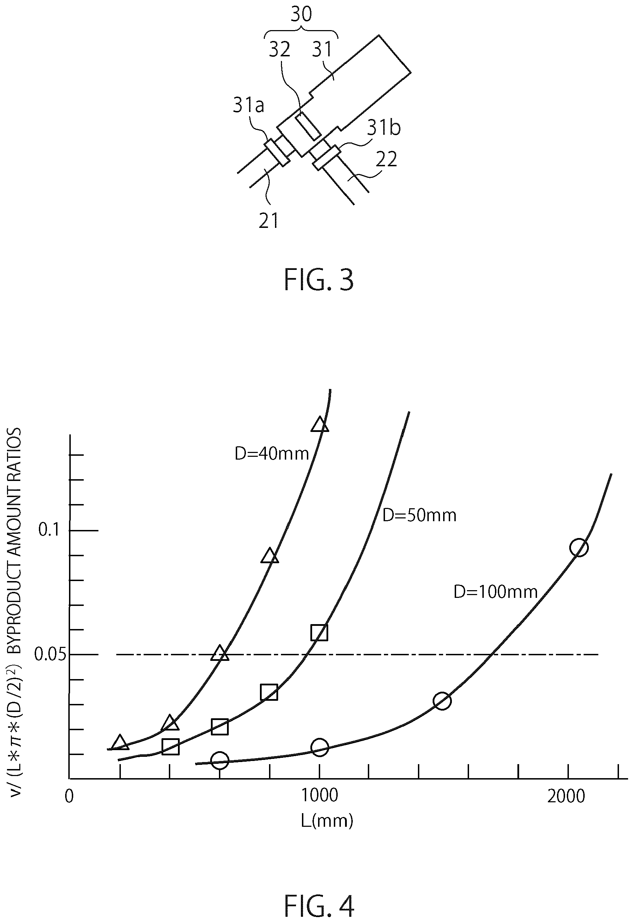

While in the present embodiment, the flow outlet 31b opens downward in the vertical direction, it only has to employ a structure which opens downward such that the byproduct X generated near the valve body 32 inside the valve 30 is guided to be discharged from the flow outlet 31b with the gravity. For example, as shown in Figure 3, the flow outlet 31b of the valve 30 may open downward obliquely.

Otherwise, the flow outlet 31b may employ a structure by which the byproduct is guided to be discharged from the valve 30 without staying there even if it opens in the horizontal direction. When the flow outlet 31b opens in the horizontal direction, piping connected thereto is also to be oriented in the horizontal direction. Nevertheless, when the length of its horizontal portion is sufficiently shorter than the diameter of that piping, the byproduct is to be guided to be discharged without staying in the valve 30

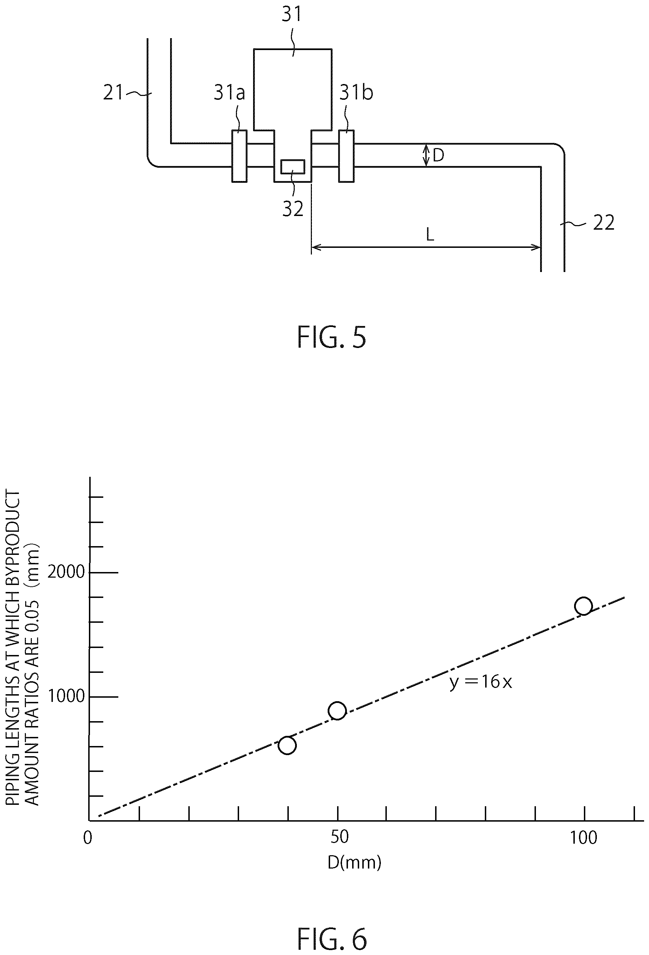

Since the length, of that horizontal portion, with which the byproduct can be discharged without staying near the valve depends on that piping diameter, there was investigated the relationship between the piping diameter (inner diameter) and the amount of remaining byproduct. The amount ("v") of the byproduct that stayed on the horizontal portion was actually measured when the length (piping length: "L") of the horizontal portion of the piping was varied up to 2000 mm at 40 mm, 50 mm, and 100 mm of inner diameter ("D") of the piping. This brought the results as shown in Figure 4. This investigation was conducted with a structure shown in Figure 5. Here, the axis of abscissas in Figure 4 denotes the length ("L") of exhaust piping in the horizontal direction, and the axis of ordinates denotes the ratio (v/V) of the amount ("v") of the byproduct that stays on the horizontal portion relative to the volume (V=(L*π*(D/2)²)) of the horizontal portion of the exhaust piping.

As shown in Figure 5, a certain amount of byproduct stays on a horizontal portion as long as the piping 22 connected from the flow outlet 31b of the valve has this horizontal portion. The amount of staying is ignorable when it is not more than about 5% of the volume of the horizontal portion of the piping. Based on this, the piping lengths "L" at which the ordinates on the plots were 0.05 in Figure 4 were obtained as in Figure 6. These three points are plotted on a straight line where the ordinates take substantially 16 times the values of the abscissas. Namely, it can be concluded that the staying in the piping is ignorable when the length of the piping is not more than 16 times the diameter of the horizontal portion of the piping. Note that it is still preferably not more than twice, further preferably not more than once, since the amount of not flowing out to the trap part 40 but staying on the horizontal portion is desirably as less as possible in view of the frequency of replacement and/or cleaning of the piping although it does not affect exhaust.

Moreover, according to the present embodiment, the trap part 40 thicker than the piping 20 (larger in piping sectional area) is connected to the downstream portion 22 at a position lower than the valve 30. Therefore, the byproduct X tends to stay more on the trap part 40 than on the valve 30. Moreover, the byproduct X can be collected in the trap part 40 without disturbing the flow of the exhaust gas G2 in the downstream portion 22.

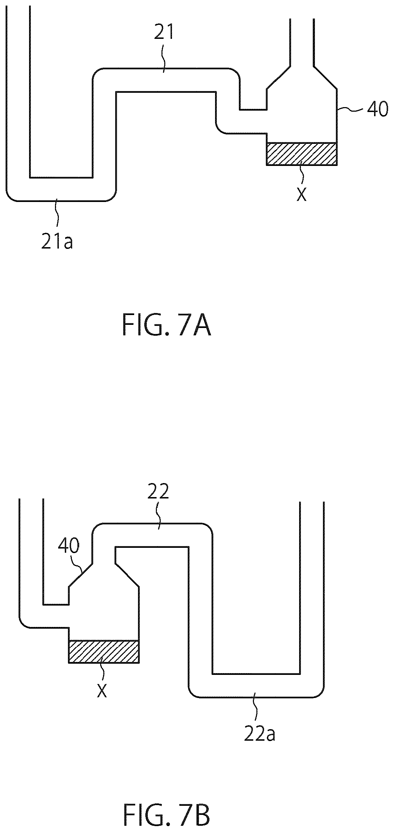

Notably, as shown in Figure 7A, the trap part 40 may be arranged on the downstream side of a lowermost part 21a of the upstream portion 21, or as shown in Figure 7B, can also be provided more on the upstream side than a lowermost part 22a of the downstream portion 22. Namely, the trap part 40 may be provided between the lowermost part 21a of the upstream portion 21 and the lowermost part 22a of the downstream portion 22.

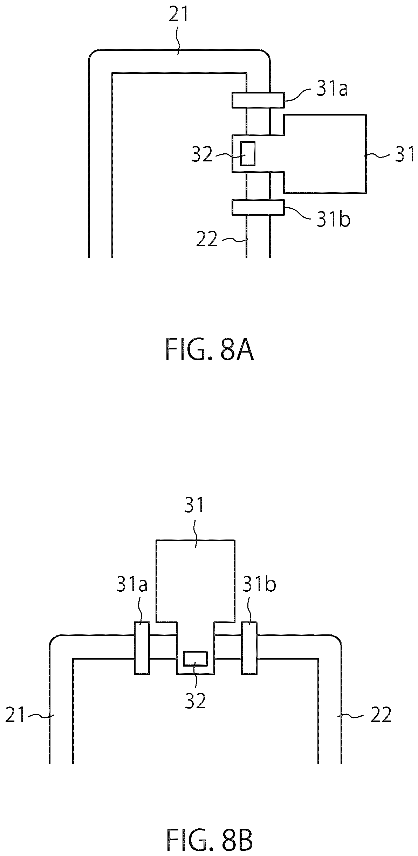

Moreover, as shown in Figure 8A, the valve 30 may have the flow inlet 31a that opens upward in the vertical direction and the flow outlet 31b that opens downward in the vertical direction.

Otherwise, as shown in Figure 8B, the valve 30 may have the flow inlet 31a and the flow outlet 31b that open to be opposite to each other in the horizontal direction.

As to the length of the piping in the horizontal direction in the stage of any of these above, this regarding the piping 22 connected from the flow outlet 31b of the valve is desirably not more than 16 times the inner diameter D of the piping as mentioned above. As to the piping 21 connected from the flow inlet 31a of the valve meanwhile, the similar investigation to that on the piping connected to the discharge port afforded the similar results to those in Figure 6. It is accordingly clear that also as to the piping 21 connected to the flow inlet 31a of the valve, the length of the horizontal portion thereof is desirably not more than 16 times the piping diameter. It is preferably not more than twice, still preferably not more than once.

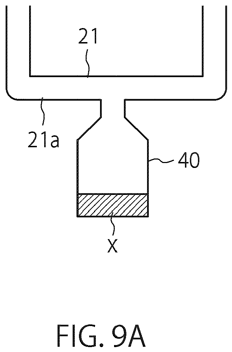

Furthermore, as shown in Figure 9A, the trap part 40 may have a structure which collects the byproduct X at a portion branching from the lowermost part of the piping 21, not in the middle thereof. With this structure, only detaching the piping 21 at one place enables replacement of the trap part 40.

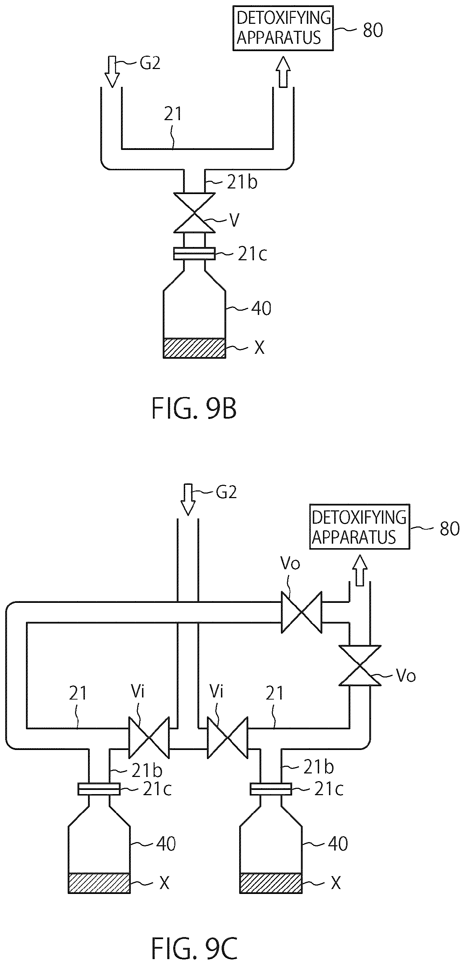

Moreover, as shown in Figure 9B, a valve V is preferably provided in the middle of vertical piping 21b which connects the piping 21 and the trap part 40. With such a configuration, the valve V is opened when the exhaust gas G2 is caused to flow (during film deposition) to collect the byproduct X in the trap part 40. Meanwhile, the valve V is closed in timing when error! the link is incorrect is not caused to flow, and the downstream side of the valve V is brought to atmospheric pressure by a pressure adjustment mechanism (not shown) to detach the trap part 40 at a separation part 21c. Then, the byproduct X collected in the trap part 40 is removed from the trap part 40, the interior of which is desirably washed by water washing or the like. After that, after the trap part 40 is connected again to be brought to reduced pressure by the pressure adjustment mechanism (not shown), the valve V is opened to be brought to the same pressure as that at the piping 21, and film deposition is performed. By doing so, not the whole piping 20 needs to be released to atmospheric air when the trap part 40 is detached, which can improve productivity.

Moreover, the valve V is closed when error! the link is incorrect is caused to flow (during film deposition) to collect the reaction byproduct X in the piping 21. The valve V is opened in timing when error! the link is incorrect is not caused to flow to transfer the byproduct collected in the piping 21 to the trap part 40. Subsequently, after the valve V is closed, the downstream side of the valve V is brought to atmospheric pressure by the pressure adjustment mechanism (not shown) to detach the trap part 40 at the separation part 21c. By doing so, since when the trap part 40 is provided upstream of the pressure control valve 31, the piping volume between the chamber 10 and the pressure control valve 31 can be made small, the pressure control using controller 70 can be more easily performed.

Furthermore, as shown in Figure 9C, the piping 21 may branch into lines on each of which valves Vi and Vo and the trap part 40 are provided. For example, by performing film deposition in the state where Vi and Vo of one line are closed and Vi and Vo of the other line are opened, the byproduct X is collected only in the trap part 40 connected to the one line. After in the state where the byproduct is collected, the pressure in the other line where the byproduct is not collected is brought to be a reduced pressure by a pressure adjustment mechanism (not shown), Vi and Vo on both sides of this line are opened, then, Vi and Vo on both sides of the line where the byproduct is collected are closed to be brought to atmospheric pressure by a pressure adjustment mechanism (not shown), and then, the trap part 40 can be detached at the separation part 21c. By doing so, the lines where the gas flows can be switched when the byproduct X is collected in the trap part 40 on one of the lines to collect the byproduct X in the trap part 40 on the other of the lines, which can more improve productivity.

### (Second Embodiment)

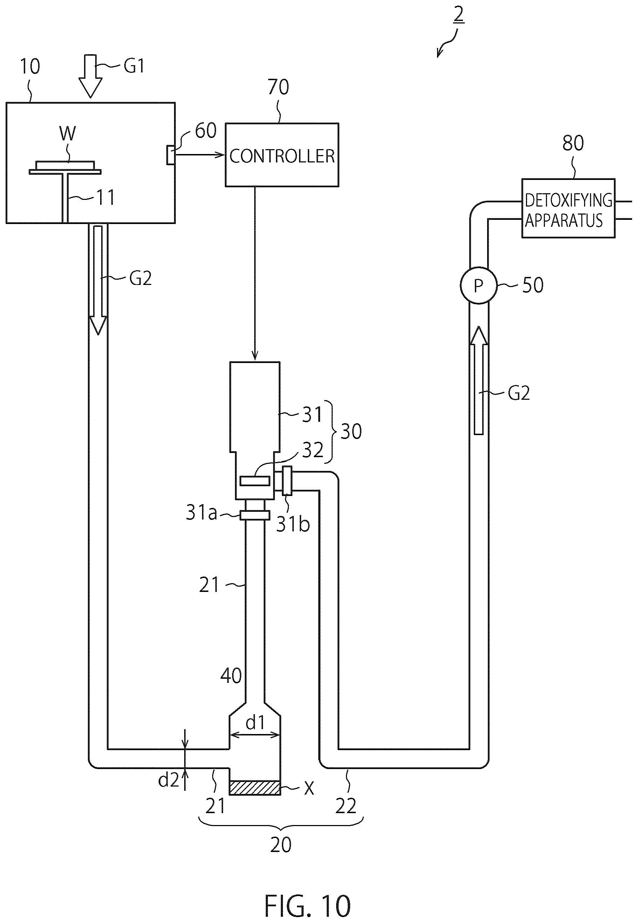

Figure 10 is a view showing a schematic configuration of a SiC epitaxial growth apparatus according to a second embodiment. In Figure 10, the similar constituents to those of the SiC epitaxial growth apparatus 1 shown in Figure 1 are given the same signs and their detailed description is omitted.

In a SiC epitaxial growth apparatus 2 shown in Figure 10, the flow outlet 31b of the valve 30 opens in the horizontal direction and is connected to the downstream portion 22 of the piping 20, and meanwhile, the flow inlet 31a thereof opens downward in the vertical direction and is connected to the upstream portion 21. Therefore, the byproduct X attaching to the vicinity of the flow inlet 31a in the valve casing 31 in discharging the exhaust gas G2 is guided to be discharged from the flow inlet 31a to the upstream portion 21 with the gravity. Since the byproduct X accordingly scarcely adheres to the interior of the valve casing 31, the frequency of replacement of the valve 30 can be reduced. The flow inlet 31a may open, in such a state, downward obliquely as shown in Figure 3 and be connected to the upstream portion 21.

Moreover, the trap part 40 is installed at a position lower than the valve 30 on the upstream portion 21. The byproduct X discharged from the flow inlet 31a can be collected in the trap part 40.

Furthermore, also in the present embodiment, the inner diameter "d1" of the trap part 40 is larger than the inner diameter "d2" of the piping 20. Therefore, the byproduct X can be collected in the trap part 40 without disturbing the flow of the exhaust gas G2 in the upstream portion 21. Notably, increase in amount of the collected byproduct X requires replacement of the trap part 40. Therefore, the trap part 40 is desirably interchangeably attached to the upstream portion 21. Moreover, another trap part 40 may be provided on the downstream portion 22 as well as that on the upstream portion 21.

Similarly to the first embodiment also in this case, the upstream portion 21 of the valve 30 may have a horizontal portion, and in this case, the length of the horizontal portion is desirably not more than 16 times the piping diameter, preferably not more than twice, still preferably not more than once.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A SiC epitaxial growth apparatus comprising:
a chamber into which a process gas at least containing silicon and carbon is introduced, the chamber being capable of housing a substrate to undergo epitaxial growth with the process gas;
piping that discharges a gas containing a byproduct generated through epitaxial growth on the substrate from the chamber; and
a valve for pressure control provided in a middle of the piping, wherein
the valve has a flow inlet into which the gas flows from an upstream portion of the piping that causes the chamber and the valve to connect with each other, and a flow outlet that allows the gas to flow out to a downstream portion of the piping that connects with the upstream portion via the valve, and
a part of the upstream portion is provided at least at a position lower than the flow inlet or a part of the downstream portion is provided at a position lower than the flow outlet.

2. The SiC epitaxial growth apparatus of Claim 1, wherein the process gas contains chlorine.

3. The SiC epitaxial growth apparatus of Claim 1, wherein at least any of the flow inlet and the flow outlet connects with piping oriented downward.

4. The SiC epitaxial growth apparatus of Claim 1, wherein the piping connecting with at least any of the flow inlet and the flow outlet has a horizontal portion, and a length of the horizontal portion is not more than 16 times a diameter of the horizontal portion.

5. The SiC epitaxial growth apparatus according to Claim 1, wherein
each of the upstream portion and the downstream portion has a lowermost part arranged between both end parts of each, and
the valve is arranged between the lowermost part of the upstream portion and the lowermost part of the downstream portion.

6. The SiC epitaxial growth apparatus according to Claim 1, further comprising a trap part that is capable of collecting the byproduct at a position lower than the valve on the upstream portion or the downstream portion.

7. The SiC epitaxial growth apparatus according to Claim 6, wherein the trap part is provided on the piping and has a larger sectional area in a plane perpendicular to a direction in which exhaust gas flows than the piping.

8. The SiC epitaxial growth apparatus according to Claim 6, wherein the trap part is detachable from the upstream portion or the downstream portion.

9. The SiC epitaxial growth apparatus of Claim 6, wherein the piping arranged at least at a position higher than the trap part is provided on at least any of the upstream portion and the downstream portion of the trap part.

10. The SiC epitaxial growth apparatus according to Claim 6, wherein the trap part is arranged at least at any of a lowermost part of the upstream portion and a lowermost part of the downstream portion.
